# EUROPÄISCHE PATENTSCHRIFT

(11) **EP 3 608 156 B1**
(45) Veröffentlichungstag und Bekanntmachung des Hinweises auf die Patenterteilung: **01.12.2021**
(21) Anmeldenummer: 19189457.5
(22) Anmeldetag: 31.07.2019
(51) Int. Cl.: B60L 53/10, B60L 53/14, G01R 31/389

(54) **VORRICHTUNG, LADESÄULE SOWIE VERFAHREN ZUR ERFASSUNG DES ZUSTANDS EINER KRAFTFAHRZEUG-BATTERIE**
DEVICE, CHARGING COLUMN AND METHOD FOR DETECTING THE CONDITION OF A MOTOR VEHICLE BATTERY
DISPOSITIF, COLONNE DE CHARGE AINSI QUE PROCÉDÉ DE DÉTECTION DE L'ÉTAT D'UNE BATTERIE DE VÉHICULE AUTOMOBILE

(30) Priorität: 10.08.2018 DE 102018213523
(43) Veröffentlichungstag der Anmeldung: 12.02.2020
(73) Patentinhaber: Volkswagen AG, 38440 Wolfsburg (DE)
(72) Erfinder: Baranski, Bernd, 22143 Hamburg (DE); Klupak, Michael, 99955 Bad Tennstedt (DE); Godehardt, Philip, 39606 Kossebau (DE); Calles, Simon, 67454 Haßloch (DE)
(74) Vertreter: FDST Patentanwälte

(56) Entgegenhaltungen:
- US-A1- 2014 145 684
- US-A1- 2015 301 121
- Mina Abedi Varnosfaderani: "Investigation of different methods of online impedance spectroscopy of batteries", , 1. Januar 2018 (2018-01-01), XP055652287, Gefunden im Internet: URL:https://publications.aston.ac.uk/id/ep rint/38929/1/Varnosfaderani_M.A._2017.pdf [gefunden am 2019-12-12]

## Beschreibung

Die Erfindung betrifft ein Verfahren zum Erfassen des Zustands der Batterie des elektrisch angetriebenen Kraftfahrzeugs mit einer Vorrichtung, wobei die Vorrichtung einen Ladestecker mit Gleichstrom-Kontakten für die Zuführung einer Ladespannung an die Batterie und eine Impedanzspektroskopieeinheit aufweist.

Ein elektrisch angetriebenes Kraftfahrzeug weist typischerweise eine Batterie (Traktions-Batterie) auf, welche eine elektrische Maschine zum Antrieb des Kraftfahrzeugs mit Energie versorgt. Dabei ist unter einem elektrisch angetriebenen Kraftfahrzeug insbesondere ein Elektrofahrzeug, welches die zum Antrieb notwendige Energie lediglich in der Batterie speichert (BEV, battery electric vehicle), ein Elektrofahrzeug mit einem Reichweitenverlängerer (REEV, range extended electric vehicle), ein Hybridfahrzeug (HEV, hybrid electric vehicle) oder ein Plug-In-Hybridfahrzeug (PHEV, plug-in hybrid electric vehicle) zu verstehen.

Im Zuge einer Wartung des Kraftfahrzeugs oder im Zuge von Qualitätssicherungsmaßnahmen ist es dabei wünschenswert, den Zustand der Batterie zu erfassen. Hierbei umfasst der Zustand insbesondere eine Funktionsfähigkeit, weiterhin ob und gegebenenfalls wie die Batterie beschädigt ist und/oder einen Alterungszustand, welcher die aktuelle Leistungsfähigkeit der Batterie oder die Leistungsfähigkeit der Batterie im Vergleich zur Leistungsfähigkeit einer solchen Batterie im Neuzustand repräsentiert.

Es sind bereits Verfahren und entsprechende Vorrichtungen bekannt, mittels welchen der Zustand einer Batterie erfasst werden kann. Beispielsweise wird hierzu eine sogenannte Impedanzspektroskopie herangezogen, mittels welcher ein zu untersuchendes Objekt (Prüfling) vergleichsweise einfach und zerstörungsfrei charakterisiert wird. Hierbei wird dem Prüfling eine Wechselspannung oder ein Wechselstrom einer vorgegebenen Frequenz als Spektroskopiesignal zugeführt und ein daraus resultierender und gegebenenfalls phasenverschobener Wechselstrom bzw. eine daraus resultierende und gegebenenfalls phasenverschobene Wechselspannung als Antwortsignal insbesondere synchron erfasst, wobei dieser Vorgang für mehrere Frequenzen eines vorgegebenen Frequenzbereichs (Spektrum) durchgeführt wird. Ein derartiges Verfahren zur Bestimmung des Ladezustandes (State of charge) einer Batterie mittels Impedanzspektroskopie ist beispielsweise in der US 2007/0090843 A1 offenbart.

Die Batterie ist typischerweise fest im Kraftfahrzeug verbaut (fixiert), so dass ein Messgerät für eine Impedanzspektroskopie nicht direkt an die Batterie anschließbar ist. Die Batterie müsste infolgedessen entweder aufwändig ausgebaut werden, oder die Batterie ist lediglich vor der Erstmontage vermessbar. Um dies zu vermeiden sind beispielsweise zusätzliche Messabgriffe vorgesehen, welche jedoch typischerweise an vergleichsweise schwer zugänglichen Stellen des Kraftfahrzeugs, beispielsweise im Motorraum, angeordnet oder erst nach Demontage eines Unterbodenschutzes zugänglich sind.

An der Batterie, insbesondere an deren Zellen, sind beispielsweise bereits Spannungssensoren vorgesehen, welche für ein Messverfahren herangezogen werden können. So sind beispielsweise aus der US 8,994,340 B2 ein Verfahren sowie ein System zur Bestimmung der Temperatur der Zellen einer Batterie bekannt. Hierzu wird zunächst mittels Impedanzspektroskopie die Impedanz der Batterie erfasst, und anschließend wird mittels der erfassten Impedanz die Temperatur der Batterie durch Vergleich mit einer Tabelle bestimmt.

Dabei erfolgt die Messung und die Auswertung beispielsweise mittels einer im Kraftfahrzeug angeordneten Steuer- oder Auswerteeinheit, wobei allerdings eine Rechenleistung für diese Vorgänge gebunden ist und nicht für andere Anwendungen zur Verfügung steht. Zudem ist es sehr aufwändig, insbesondere im Zuge einer Qualitätssicherungsmaßnahme, mehrere Kraftfahrzeuge miteinander zu vergleichen.

In der US 2015/0301121 A1 ist eine Vorrichtung zum Schätzen einer Batterielebensdauer beschrieben. Die Vorrichtung weist einen Batteriemonitor, der so konfiguriert ist, dass er ein Ausgangssignal von einer Batterie überwacht; einen Stationärzustandsdetektor, der so konfiguriert ist, dass er einen ersten stationären Zustand, in dem das Ausgangssignal in einem stationären Zustand bleibt, und einen zweiten stationären Zustand, der sich von dem ersten stationären Zustand unterscheidet, erfasst, auf. Die Vorrichtung weist weiterhin einen Schätzer, der so konfiguriert ist, dass er eine Batterielebensdauer aus einer Änderung des Ausgangssignals in einem Übergangszustand, in dem das Ausgangssignal von dem ersten stationären Zustand in den zweiten stationären Zustand übergeht, schätzt, auf.

Aus der US 2014/0145684 A1 ist es bekannt eine wiederaufladbare Batterie in mehreren diskreten Ladeintervallen diskontinuierlich aufzuladen. Hierbei werden Verringerungen der Batteriespannung, welche während Nichtladeintervallen auftreten, gemessen. Verfahrensgemäß werden mehrere Widerstandswerte, welche den Innenwiderstand (Gleichstromwiderstand) der Batterie charakterisieren, anhand der Verringerungen der Batteriespannung bestimmt.

Der Erfindung liegt die Aufgabe zugrunde, ein geeignetes Verfahren zur Erfassung des Zustands der Batterie des elektrisch angetriebenen Kraftfahrzeugs mittels einer Vorrichtung anzugeben. Insbesondere soll dabei die Erfassung des Zustandes der Batterie möglichst aufwandsarm erfolgen

Die Aufgabe wird erfindungsgemäß gelöst mit den Merkmalen des Anspruchs 1. Vorteilhafte Ausgestaltungen und Weiterbildungen sind Gegenstand des Unteranspruchs. Dabei gelten die Ausführungen im Zusammenhang mit der Vorrichtung sinngemäß auch für das Verfahren sowie für die Ladesäule und umgekehrt.

Die Vorrichtung dient der Erfassung des Zustands einer Batterie eines elektrisch angetriebenen Kraftfahrzeugs. Hierzu weist die Vorrichtung einen Ladestecker mit Gleichstromkontakten für die Zuführung einer Ladespannung an die Batterie auf. Des Weiteren umfasst die Vorrichtung ein als Impedanzspektroskopieeinheit bezeichnetes Messgerät zur Aufnahme von Impedanzspektren. Dabei ist die Impedanzspektroskopieeinheit sowohl zum Zuführen eines Spektroskopiesignals an die Batterie als auch zum Erfassen eines Antwortsignals mit den Gleichstromkontakten des Ladesteckers verbunden. Auf diese Weise sind keine zusätzlichen Kontakte und/oder Stecker zum anschließen der Impedanzspektroskopieeinheit an die Batterie notwendig.

Zudem ist der Ladestecker zum Anschließen an eine Gleichstrom-Ladeschnittstelle des elektrisch angetriebenen Kraftfahrzeugs vorgesehen und eingerichtet. Der Ladestecker ist dabei vorzugsweise derart ausgebildet, dass er weiterhin geltende Normen und Vorschriften, beispielsweise ISO-Normen, erfüllt. Der Ladestecker ist jedenfalls dazu geeignet (vorgesehen und eingerichtet), der Batterie des elektrisch angetriebenen Kraftfahrzeugs eine als Gleichspannung ausgebildete Ladespannung über die Gleichstrom-Ladeschnittstelle zuzuführen.

Vorteilhafterweise ist die Impedanzspektroskopieeinheit auf einfache Art durch Anschließen des Ladesteckers an die für diesen vorgesehene Gleichstrom-Ladeschnittstelle des Kraftfahrzeugs elektrisch verbunden, wobei die Gleichstrom-Ladeschnittstelle zweckmäßigerweise einen Bestandteil einer entsprechenden Ladedose bildet. Es werden also bereits in das Kraftfahrzeug integrierte Vorrichtungen verwendet, um die Batterie zu vermessen. Die Gleichstrom-Ladeschnittstelle des Kraftfahrzeugs ist zudem einfach zugänglich. Zusätzliche Demontageschritte zum Erfassen des Zustands der Batterie sind somit nicht notwendig.

In zweckmäßiger Ausgestaltung weist die Impedanzspektroskopieeinheit zwei Speiseleitungen zum Zuführen des Spektroskopiesignals und zwei Messleitungen zum Erfassen des Antwortsignals auf. Jeder der Gleichstromkontakte ist dabei jeweils mit einer der Speiseleitungen sowie mit einer der Messleitungen verbunden. Mit anderen Worten ist eine der Speiseleitungen mit einem der Gleichstromkontakte und die andere Speiseleitung mit dem anderen Gleichstromkontakt verbunden. Analog ist eine der Messleitungen mit einem der Gleichstromkontakte und die andere Messleitung mit dem anderen Gleichstromkontakt verbunden.

Die Gleichstromkontakte sind dabei über entsprechende Ladeanschlüsse der Gleichstrom-Ladeschnittstelle mit jeweils einem Anschlusspol der Batterie verbunden. Dabei ist beispielsweise zusätzlich eine Schutzvorrichtung eines die Batterie umfassenden Batterieladesystems zwischen den Ladeanschlüssen und der Batterie geschaltet. Insofern sind die Ladeanschlüsse mit der Batterie verbunden, wenn die Schutzvorrichtung geschlossen ist. Dann ist es ermöglicht, mittels der Speiseleitungen und mittels der Messleitungen der Batterie ein Spektroskopiesignal aufzuprägen und das entsprechende Antwortsignal zu erfassen.

Gemäß einer geeigneten Ausgestaltung weist die Vorrichtung weiterhin eine Steuervorrichtung für die Impedanzspektroskopieeinheit und zur Kommunikation mit einer auch als Batteriemanagementsystem bezeichneten Steuereinheit des Batterieladesystems auf. Auf diese Wiese kann und wird das Spektroskopiesignal derart zugeführt, dass aufgrund des Spektroskopiesignals kein Fehler bei der Kommunikation hervorgerufen wird, oder dass eine unkorrekte Interpretation des Spektroskopiesignals durch die Steuervorrichtung des Batterieladesystems als ein Fehlerstrom oder eine Fehlerspannung vermieden ist. Insbesondere wird das Spektroskopiesignal zu einem dafür geeigneten Zeitpunkt ausgegeben.

Beispielsweise ist der Ladestecker zur Kommunikation zusätzlich zu den Gleichstromkontakten mit einem weiteren Kontakt versehen, welcher auch als Kommunikationskontakt oder Pilotleitung bezeichnet wird. Zweckmäßigerweise weist die Gleichstrom-Ladeschnittstelle einen entsprechenden Kommunikationsanschluss für den Kommunikationskontakt auf, welcher Kommunikationsanschluss wiederum mit der Steuereinheit des Batterieladesystems verbunden ist.

Die Kommunikation zwischen der Steuervorrichtung und der Steuereinheit erfolgt alternativ drahtlos. Hierzu weist der Ladestecker eine mit der Steuervorrichtung verbundene Empfangs- und Sendeeinheit auf, mittels welcher Daten und/oder Signale per Funk an eine entsprechende mit der Steuereinheit verbundene Empfangs- und Sendeeinheit übertragen werden können.

Gemäß einer vorteilhaften Ausgestaltung sind die Steuervorrichtung und zusätzlich oder alternativ die Impedanzspektroskopieeinheit in einem Gehäuse des Ladesteckers angeordnet. Mit anderen Worten sind die Steuervorrichtung und/oder die Impedanzspektroskopieeinheit in den Ladestecker integriert. So ist eine platzsparende Ausgestaltung der Vorrichtung realisiert.

Die Vorrichtung weist des Weiteren in zweckmäßiger Ausgestaltung einen Anschluss für ein Versorgungsnetz auf. Dies dient der Bereitstellung der Ladespannung für die Batterie mittels der Gleichstromkontakte. Zweckmäßig sind hierzu die Gleichspannungskontakte mit dem Anschluss verbunden. Geeigneter Weise sind auch die Impedanzspektroskopieeinheit und/oder die Steuervorrichtung zu deren Energieversorgung mit dem Anschluss verbunden. Sofern das Versorgungsnetz eine Wechselspannung bereitstell, ist zweckmäßig ein Gleichrichter zwischen dem Anschluss und den Gleichstromkontakten geschaltet.

Vorzugsweise ist der Anschluss für ein Haushaltsstromnetz, beispielsweise ein 230V Wechselstrom-Versorgungsnetz, ausgebildet. Infolgedessen ist die Vorrichtung auch als Messgerät für Werkstätten oder für den Benutzer des Fahrzeugs geeignet.

In vorteilhafter Ausgestaltung weist die Vorrichtung eine Stromüberwachungseinheit auf, welche im Fehlerfall die Gleichstromkontakte vom Versorgungsnetz trennt. Mit anderen Worten wird mittels der Stromüberwachungseinheit im Fehlerfall das Versorgungsnetz weggeschaltet, also eine elektrische Verbindung der Gleichstromkontakte zum an das Versorgungsnetz angeschlossenen Anschluss unterbrochen. Zusammenfassend dient die Stromüberwachungseinheit dem netzseitigen Abschalten im Fehlerfall. Hierbei ist unter einem Fehlerfall insbesondere ein Überschreiten eines vorgegebenen Schwellwerts durch einen beim Laden der Batterie fließenden (Lade-)Strom zu verstehen.

In vorteilhafter Weiterbildung weist eine Ladesäule, welche dem Laden der Batterie eines elektrisch angetriebenen Kraftfahrzeugs dient, eine Vorrichtung in einer der oben dargelegten Varianten auf. Insbesondere ist dabei die Impedanzspektroskopieeinheit mit den Gleichstromkontakten des Ladesteckers der Ladesäule verbunden. Beispielsweise sind dabei die Impedanzspektroskopieeinheit und/oder die Steuervorrichtung im Gehäuse des Ladesteckers der Ladesäule integriert. Insbesondere ist die Vorrichtung des Weiteren an das Versorgungsnetz der Ladesäule angeschlossen.

Gemäß dem erfindungsgemäßen Verfahren zum Erfassen des Zustands der Batterie des elektrisch angetriebenen Kraftfahrzeugs wird zunächst der Ladestecker der Vorrichtung mit der Gleichstrom-Ladeschnittstelle des Kraftfahrzeugs verbunden. So sind die Gleichstromkontakte mit den Ladeanschlüssen und der Kommunikationskontakt mit dem Kommunikationsanschluss verbunden (elektrisch kontaktiert).

Beispielsweise findet anschließend ein Kommunikationsaufbau der Steuervorrichtung und der Steuereinheit statt. Dabei wird durch einen Austausch geeigneter Signale und/oder Daten das Laden der Batterie vorbereitet. Hierbei wird beispielsweise dem Kraftfahrzeug der entsprechende Ladestecker zugeordnet und eine eindeutige (Verbindungs-)Identifikation vergeben. Beispielsweise zusätzlich werden Parameter übertragen, welche einen maximalen Ladestrom oder eine maximale Ladespannung repräsentieren. Insbesondere sind auf diese Weise Normen und Sicherheitsrichtlinien genügt.

Typischerweise weist das Batterieladesystem eine Schutzvorrichtung (ein Schutz) für die Batterie auf. Beispielswiese ist die Schutzvorrichtung als ein Schaltelement ausgebildet, wobei die Batterie entsprechend der Schalterstellung den Ladeanschlüssen zugeschaltet oder weggeschaltet ist. Das Spektroskopie-signal ist also je nach Schalterstellung der Batterie zuführbar bzw. nicht zuführbar. Um den Zustand der Batterie zu erfassen, ist es also zunächst notwendig, dass die Schutzvorrichtung des Batterieladesystems geschlossen bzw. deaktiviert wird. Hierbei ist unter einer geschlossen bzw. deaktivierten Schutzvorrichtung zu verstehen, dass die Batterie den Ladeanschlüssen zugeschaltet ist. Hierzu wird das Batterieladesystem in einen Ladebetriebszustand versetzt. Mit anderen Worten wird hierzu der Ladebetriebszustand des Batterieladesystems aktiviert.

Die Schutzvorrichtung soll insbesondere eine Lastspitze und eine damit einhergehende mögliche Beschädigung des Batterieladesystems, insbesondere der Batterie, beim Zuschalten der Batterie an die mit der Ladespannung beaufschlagten Ladenschlüsse vermeiden. Hierzu wird in einer zweckmäßigen Weiterbildung des Verfahrens zunächst der Ladezustand (State auf Charge, SOC) der Batterie erfasst, wobei anhand des Ladezustands auf die von der Batterie bereitgestellte (Batterie-)Spannung geschlossen wird, oder alternativ wird die Batteriespannung direkt erfasst. Dem folgend wird die Ladespannung in Abhängigkeit des Batterieladezustands oder in Abhängigkeit der von der Batterie bereitgestellten (Batterie-)Spannung eingestellt, was als Vorladen (Precharging) bezeichnet wird. Anschließend wird die Ladespannung dem Batterieladesystem mittels der Verbindung des Ladesteckers mit der Gleichstrom-Ladeschnittstelle bereitgestellt.

Dabei wird die Schutzvorrichtung insbesondere dann leitend geschaltet (geschlossen), wenn die eingestellte Ladespannung größer als oder gleich der dem Ladezustand der Batterie entsprechenden Batteriespannung ist. Damit die Schutzvorrichtung im geschlossen Zustand bleibt, ist beispielsweise eine zusätzliche Voraussetzung, dass die Ladespannung und/oder der Ladestrom während des Ladebetriebszustands kleiner als eine vorgegebene maximale Ladespannung oder ein vorgegebener maximaler Ladestrom ist und bleibt.

Insbesondere sofern die Vorrichtung nicht in eine Ladesäule integriert ist, also als separates Messgerät ausgebildet ist, ist es zweckmäßig, dass kein bzw. lediglich ein vergleichsweise geringer Ladestrom für die Batterie bereitgestellt wird. Also wird die Batterie nicht oder lediglich in vernachlässigbarem Maße geladen, das Batterieladysystem aber dennoch in den Ladebetriebszustand versetzt. Deshalb wird dies zusammenfassend als Simulation des Ladens der Batterie mittels einer Ladesäule bezeichnet. Beispielsweise sind dann aufgrund des geringen Ladestroms oder des Fehlens des Ladestroms die an die Gleichstromkontakte des Ladesteckers angeschlossenen Leiter (Kabel) vergleichsweise dünn, d. h. mit entsprechend geringem Leiterquerschnitt ausgebildet.

Alternativ zur Simulation des Ladens der Batterie, insbesondere sofern die Vorrichtung in eine Ladesäule integriert ist, wird die Batterie nach dem Versetzten in den Ladebetriebszustand mittels eines als Gleichstrom ausgebildeten Ladestroms geladen, welcher eine für das Laden, insbesondere für einen Schnelladevorgang, vorgesehene und geeignete Stromstärke aufweist.

Allenfalls ist nach dem Versetzen des Batterieladesystems in den Ladebetriebszustand die Batterie über die Ladeschlüsse mit den Gleichstromkontakten der Vorrichtung elektrisch verbunden (zugeschaltet). Somit kann und wird der Batterie für mehrere Frequenzen eines vorgegebenen Frequenzbereichs zeitlich nacheinander jeweils ein Spektroskopiesignal von der Impedanzspektroskopieeinheit zugeführt, und beispielsweise synchron, insbesondere zeitgleich, wird ein entsprechendes Antwortsignal erfasst. Dabei ist das Spektroskopiesignal als eine Wechselspannung oder ein Wechselstrom und das Antwortsignal entsprechend als Wechselstrom bzw. Wechselspannung ausgebildet.

Aus den Ergebnissen der Impedanzspektroskopie, insbesondere den Amplituden des Wechselstroms unter Wechselspannung sowie deren Phasenversatz zueinander und einer Frequenzabhängigkeit der daraus bestimmten Impedanz der Batterie, wird darauf folgend ein den Zustand der Batterie repräsentierender Wert mittels aus dem Stand der Technik an sich bekannter Verfahren ermittelt. Beispielsweise werden eine Übergangsfrequenz, bei welcher keine Phasenverschiebung zwischen dem Spektroskopie- und dem Antwortsignal vorliegt, und/oder der entsprechende elektrische Widerstand bestimmt. Diese bzw. dieser wiederum ist abhängig vom Alterungszustand. So kann der Alterungszustand beispielsweise durch einen Vergleich der Übergangsfrequenz bzw. des Widerstands mit einer in der Steuervorrichtung hinterlegten Tabelle ermittelt werden.

Unter dem Zustand der Batterie ist insbesondere deren Funktionsfähigkeit oder ein Alterungszustand zu verstehen, welcher deren aktuelle Leistungsfähigkeit oder deren Leistungsfähigkeit im Vergleich zur Leistungsfähigkeit einer solchen Batterie im Neuzustand repräsentiert. Weiter beispielsweise ist unter dem Zustand der Batterie zu verstehen, ob und gegebenenfalls wie die Batterie beschädigt ist, sowie deren Temperatur und/oder deren Ladezustand.

Insbesondere umfasst die Batterie eine Anzahl von in Serie und/oder parallel geschalteten (Zell-)Modulen, welche wiederum mittels einer Anzahl an sogenannten Zellen, insbesondere Lithium-Ionen-Zellen, gebildet sind. Mittels des oben dargelegten Verfahrens kann zusammenfassend anhand des erfassten Impedanzspektrums der Zustand der Batterie erfasst werden.

Nachfolgend werden Ausführungsbeispiele der Erfindung anhand einer Zeichnung näher erläutert. Darin zeigen:
- Fig. 1: in einem Blockschaltdiagramm eine an ein Versorgungsnetz angeschlossene Vorrichtung mit einer Impedanzspektroskopieeinheit, deren Messleitungen und deren Speiseleitungen mit Gleichstrom-Kontakten eines Ladesteckers verbunden sind,
- Fig. 2: schematisch eine Ladesäule zum Laden einer Batterie eines elektrisch angetriebenen Kraftfahrzeugs, wobei die Vorrichtung in die Ladesäule integriert ist, und
- Fig. 3: in einem Flussdiagramm einen Verfahrensablauf zum Erfassen des Zustand der Batterie des elektrisch angetriebenen Kraftfahrzeugs mittels der Vorrichtung.

Einander entsprechende Teile und Größen sind in allen Figuren stets mit gleichen Bezugszeichen versehen.

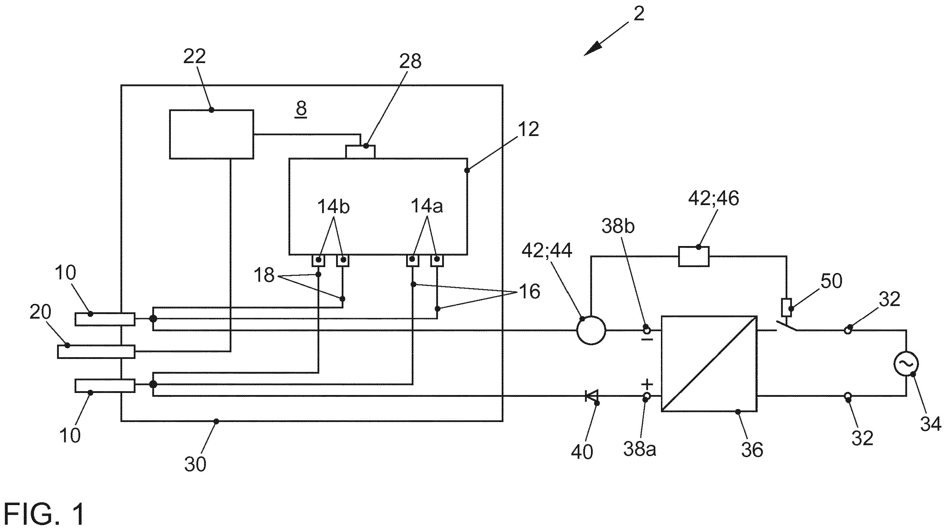

In der Fig. 1 ist eine Vorrichtung 2 zur Erfassung des Zustands einer (Traktions-)Batterie 4 eines elektrisch angetriebenen Kraftfahrzeugs 6 dargestellt. Die Vorrichtung 2 umfasst einen Ladestecker 8 mit zwei Gleichstromkontakten 10 für die Zuführung einer Ladespannung U_{L} an die Batterie 4. Des Weiteren weist die Vorrichtung 2 ein als Impedanzspektroskopieeinheit 12 bezeichnetes Messgerät zur Aufnahme von Impedanzspektren auf. Diese weist zwei Anschlüsse 14a für jeweils eine Speiseleitung 16 zum Zuführen eines Spektroskopiesignals (Speisesignals, Force-Signals) S sowie zwei Anschlüsse 14b für jeweils eine Messleitung 18 zur Erfassung eines entsprechenden Antwortsignals (Messsignal, Sense-Signal) A auf. Dabei ist an jedem der Gleichstromkontakte 10 jeweils eine der Speiseleitungen 16 und eine der Messleitungen 18 angeschlossen (elektrisch verbunden).

Zusammenfassend ist die Impedanzspektroskopieeinheit 12 sowohl zum Zuführen des Spektroskopiesignals S als auch zum Erfassen des Antwortsignals A mit den Gleichstromkontakten 10 des Ladesteckers 8 verbunden.

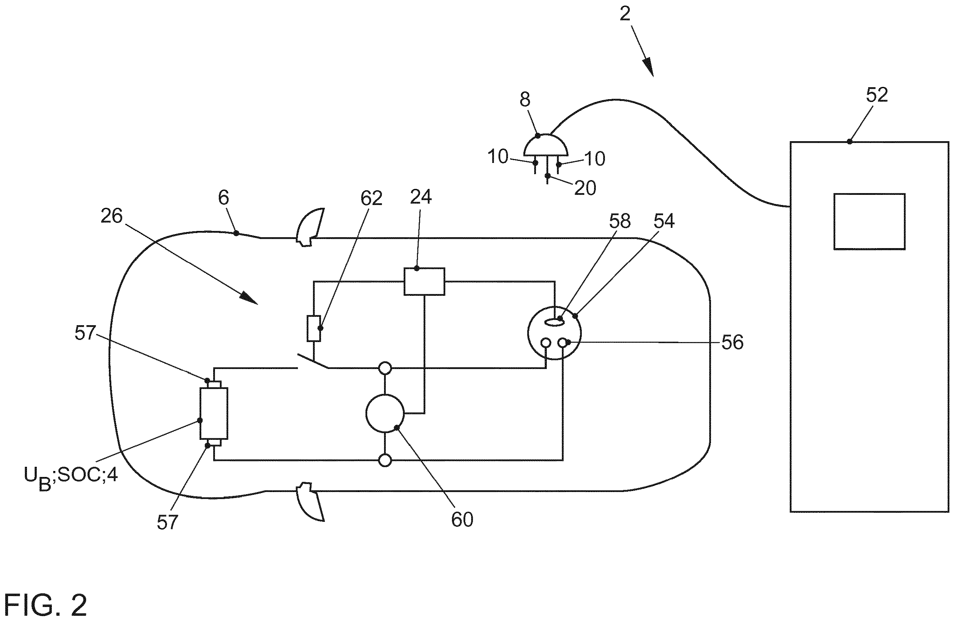

Der Ladestecker 8 weist des Weiteren einen Kommunikationskontakt 20 (Pilotleitung) auf, welcher mit einer Steuervorrichtung 22 verbunden ist. Die Steuervorrichtung 22 dient dem Zweck, mit einer auch als Batterie-Management-System bezeichneten Steuereinheit 24 eines die Batterie 4 umfassenden Batterieladesystems 26 des Kraftfahrzeugs 6 zu kommunizieren (Fig. 2). Hierzu werden beispielsweise Daten und/oder Signale zwischen der Steuervorrichtung 22 und der Steuereinheit 24 ausgetauscht. Auf diese Weise werden beispielsweise zum Initialisieren des Ladevorgangs der Batterie 4 oder während des Ladevorgangs der Batterie 4 standardisierte Protokolle ausgeführt, welche insbesondere Normen und Sicherheitsvorschriften genügen.

Gemäß einer nicht weiter dargestellten Alternativen erfolgt die Kommunikation zwischen der Steuervorrichtung 22 und der Steuereinheit 24 drahtlos. Die hierzu erforderlichen Empfangs- und Sendeeinheiten, sind dabei zusätzlich oder alternativ zum Kommunikationskontakt 20 und dem Kommunikationsanschluss 58 vorhanden. Beispielsweise ist die Empfangs- und Sendeeinheit der Vorrichtung im Gehäuse des Ladesteckers 8 angeordnet.

Weiterhin ist die Steuervorrichtung 22 an einen Steuereingang 28 der Impedanzspektroskopieeinheit 12 angeschlossen. Infolgedessen ist es ermöglicht, dass die Ausgabe des Spektroskopiesignals S in einem dafür geeigneten Zeitfenster erfolgt, so dass kein Fehler im Zuge der Kommunikation zwischen der Steuervorrichtung 22 und der Steuereinheit 24 hervorgerufen wird. In der Ausführung der Fig. 1 sind sowohl die Steuervorrichtung 22 als auch die Impedanzspektroskopieeinheit 12 in einem Gehäuse 30 des Ladesteckers 8 angeordnet. So sind die Steuervorrichtung 22 und die Impedanzspektroskopieeinheit 12 im Ladestecker 8 integriert. In einer nicht weiter dargestellten alternativen Ausgestaltung ist die Impedanzspektroskopieeinheit 12 und/oder die Steuervorrichtung 22 in einem separaten Gehäuse angeordnet.

Die Vorrichtung 2 weist weiterhin einen Anschluss 32 auf, mittels welchem die Gleichstromkontakte 10 an ein Versorgungsnetz 34 angeschlossen sind, welches hier als eine Wechselspannungsquelle ausgebildet ist. Die vom Versorgungsnetz 34 bereitgestellte Wechselspannung wird mittels eines Gleichrichters 36 der Vorrichtung 2 gewandelt, welcher zwischen dem Anschluss 32 und dem Ladestecker 8 geschaltet ist. Die gleichgerichtete Spannung ist folglich an den Gleichstromkontakten 10 des Ladesteckers als Ladespannung U_{L} abgreifbar.

Die Vorrichtung 2 weist des Weiteren mehrere Sicherheitsvorrichtungen auf. So ist zwischen dem positiven Anschluss (Phasenanschluss) 38a des Gleichrichters und dem an diesen angeschlossenen Gleichstromkontakt 10 eine Diode 40 geschaltet, welche einen Stromfluss vom Gleichstromkontakt 10 zum Versorgungsnetz 34 und somit eine Beschädigung der Vorrichtung 2 verhindert. Zusätzlich ist zwischen dem negativen Anschluss (Masseanschluss) 38b des Gleichrichters 36 und dem an diesem angeschlossenen Gleichstromkontakt 10 eine Stromüberwachungseinheit 42 geschaltet, welche im Fehlerfall die Verbindung der Gleichstromkontakte 10 der Vorrichtung 2 zum Versorgungsnetz 34 trennt.

Unter einem Fehlerfall ist dabei insbesondere ein Überschreiten eines vorgegebenen Schwellwerts durch den beim Laden der Batterie 4 fließenden (Lade-)Strom zu verstehen. Hierzu weist die Stromüberwachungseinheit 42 ein Strommessgerät 44 auf, welche ein den Ladestrom repräsentierendes und insbesondere als eine Spannung ausgebildetes Signal an eine Vergleichseinheit (Komparator) 46 ausgibt. Diese wiederum ist an einen Schalter 50 angeschlossen, sodass der Schalter 50 im Fehlerfall öffnet und den Strompfad zwischen dem Versorgungsnetz 34 und dem Gleichrichter 36 unterbricht. Somit dient der Schalter 50 zum netzseitigen Abschalten der Vorrichtung 2 im Fehlerfall.

In Fig. 2 ist eine Ladesäule 52 zum Laden der (Traktions-)Batterie 4 des elektrisch angetriebenen Kraftfahrzeugs 6 dargestellt, wobei deren Ladestecker 8 zum Anschließen an eine Gleichstrom-Ladeschnittstelle 54 des Kraftfahrzeugs 6 vorgesehen und eingerichtet ist. Dabei ist die Impedanzspektroskopieeinheit 12 in nicht näher dargestellter Weise mit den Gleichstromkontakten 10 des Ladesteckers 8 verbunden. Die Impedanzspektroskopieeinheit 12 ist also im Gehäuse 30 des Ladesteckers 8 der Ladesäule 52 gemäß der in Fig. 1 dargelegten Weise integriert. Die Vorrichtung 2 ist des Weiteren in nicht näher dargestellter Weise mit dem Versorgungsnetz 34 der Ladesäule 52 verbunden.

Die Gleichstrom-Ladeschnittstelle 54 des elektrisch angetriebenen Kraftfahrzeugs weist zwei Ladeanschlüsse 56 für die Gleichstromkontakte 10 sowie einen Kommunikationsanschluss 58 für den Kommunikationskontakt 20 des Ladesteckers 8 der Vorrichtung 2 auf. Hierbei ist zum Zwecke der Übersichtlichkeit lediglich einer der beiden Ladeanschlüsse 56 mit einem Bezugszeichen versehen. Die Ladeanschlüsse 56 für die Gleichstromkontakte 10 des Ladesteckers 8 sind jeweils an einem Anschlusspol 57 der Batterie 4 angeschlossen. Die (Traktions-)Batterie 4 ist zum Zwecke einer besseren Übersichtlichkeit schematisch dargestellt. Diese umfasst eine Anzahl von in Serie und/oder parallel geschalteten (Zell-)Modulen, welche wiederum mittels einer Anzahl an sogenannten Zellen, insbesondere Lithium-Ionen-Zellen, gebildet sind.

Parallel zur Batterie 4 ist ein Spannungsmessgerät 60 geschaltet, welches die Spannung zwischen den Ladeanschlüssen 56 erfasst. Das Spannungsmessgerät 60 ist an die Steuereinheit 24 des Batterieladesystems 26 angeschlossen. Die Steuereinheit 24 ist wiederum mit einer hier als Schutzschalter 62 ausgebildeten Schutzvorrichtung verbunden. Der Schutzschalter 62 ist dabei zwischen einen der Anschlusspole 57 der Batterie 4 und den entsprechenden Ladeanschluss 56 geschaltet. Je nach Schalterstellung des Schutzschalters 62 ist die Batterie 4 auf diese Weise den Ladeanschlüssen 56 zugeschaltet oder weggeschaltet. So liegt je nach Schalterstellung die Spannung zwischen den Ladeanschlüssen 56 an der Batterie 4 an bzw. nicht an. Entsprechend ist das Spektroskopiesignal A der Batterie zuführbar oder nicht zuführbar. Des Weiteren ist die Steuereinheit 24 mit dem Kommunikationsanschluss 58 der Gleichstrom-Ladeschnittstelle 54 verbunden, sodass es ermöglicht ist, den Schutzschalter 62 bei fehlerhafter Kommunikation zwischen der Steuervorrichtung 22 und der Steuereinheit 24 oder bei Empfang eines entsprechenden (Abschalt-)Signals zu betätigen.

Zusammenfassend umfasst das Batterieladesystem 26 die Steuereinheit 24, den Schutzschalter 62, das Spannungsmaßmessgerät 60, die Batterie 4 sowie die Gleichstrom-Ladeschnittstelle 54.

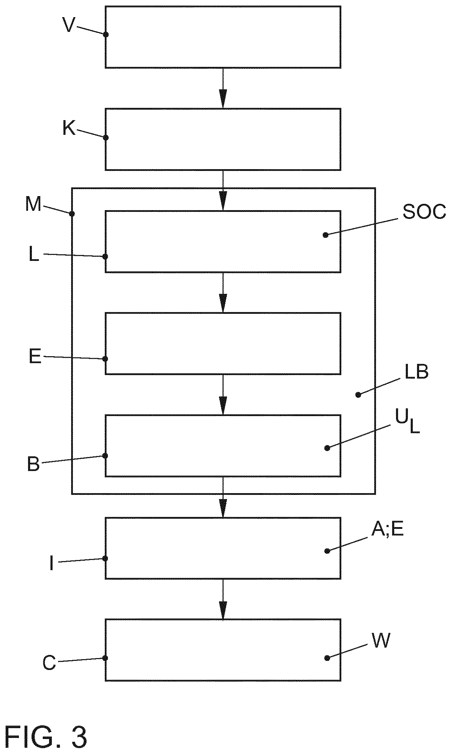

Das in Fig. 3 gezeigte Flussdiagramm repräsentiert einen Verfahrensablauf zum Erfassen des Zustands der Batterie 4 des elektrisch angetriebenen Kraftfahrzeugs 6 mittels der Vorrichtung 2.

Hierbei wird in einem ersten Schritt V der Ladestecker 8 der Vorrichtung 2 mit der Gleichstrom-Ladeschnittstelle 54 des Kraftfahrzeugs 6 verbunden. So sind die Gleichstromkontakte 10 mit den Ladeanschlüssen 56 und der Kommunikationskontakt 20 mit dem Kommunikationsanschluss 58 elektrisch kontaktiert. Im darauffolgenden Schritt K findet ein Kommunikationsaufbau der Steuervorrichtung 22 und der Steuereinheit 24 statt. So startet im Schritt K die Kommunikation zwischen Steuervorrichtung 22 und Steuereinheit 24, wobei durch einen Austausch geeigneter Signale und/oder Daten das Laden der Batterie 4 vorbereitet wird. Hierbei wird beispielsweise dem Kraftfahrzeug 6 der entsprechenden Ladestecker 8 zugeordnet und eine eindeutige (Verbindungs-)Identifikation vergeben. Zudem werden beispielsweise Parameter übertragen, welche einen maximalen Ladestrom oder eine maximale Ladespannung U_{L} repräsentieren.

Um den Zustand der Batterie 4 zu erfassen, ist es zunächst notwendig, dass die Schutzvorrichtung (der Schutz) des Batterieladesystems 26 für die Batterie 4 geschlossen wird, welche Schutzvorrichtung in der Figur 2 repräsentativ als Schutzschalter 54 ausgebildet ist. Hierzu wird das Batterieladesystem 26 in einen Ladebetriebszustand LB versetzt. Mit anderen Worten wird hierzu der Ladebetriebszustand LB des Batterieladesystems 26 aktiviert. Dies erfolgt durch eine im Folgenden näher beschriebene Simulation des Ladens der Batterie vermittels einer Ladesäule.

Im Zuge der Simulation (Schritt M) wird zunächst der Ladezustand SOC der Batterie (State auf Charge) erfasst (Schritt L). In Abhängigkeit dieses erfassten Ladezustands SOC wird die Ladespannung U_{L} für die Batterie 4 an den Gleichstromkontakten 10 des Ladesteckers 8 eingestellt (Schritt E). Hierzu wird dem Ladezustand SOC eine diesem entsprechende Batteriespannung U_{B} zugeordnet. Gemäß einer nicht weiter dargestellten Alternative wird die Batteriespannung U_{B} direkt erfasst und die Ladespannung U_{L} entsprechend eingestellt.

Dieser Vorgang wird auch als Vorladen (Precharging) bezeichnet. Die derart eingestellte Ladespannung U_{L} wird dem Batterieladesystem 26 mittels der Verbindung des Ladesteckers 8 mit der Gleichstrom-Ladeschnittstelle 54 bereitgestellt (Schritt B). Insbesondere wird der Schutzschalter leitend geschaltet (geschlossen), sofern die eingestellte Ladespannung U_{L} größer als oder gleich der dem Ladezustand SOC der Batterie entsprechenden Batteriespannung U_{B} ist. So entstehen aufgrund des Vorlandens beim Zuführen der Ladespannung U_{L} an die Batterie 4 keine Lastspitzen beim Schließen des Schutzschalters 54, und eine Beschädigung der Vorrichtung 2 und/oder des Batterieladesystems 26 ist vermieden.

Infolgedessen ist die Batterie 4 über die Ladeschlüsse 56 den Gleichstromkontakte 10 der Vorrichtung 2 zugeschaltet, also mit diesen elektrisch verbunden. Auf diese Weise ist es ermöglicht, dass der Batterie 4 für mehrere Frequenzen eines vorgegebenen Bereichs jeweils ein Spektroskopiesignal S, welches als eine Wechselspannung oder ein Wechselstrom ausgebildet ist, von der Impedanzspektroskopieeinheit 12 zugeführt und ein entsprechendes Antwortsignal A, welches als Wechselstrom bzw. Wechselspannung ausgebildet ist, erfasst wird (Schritt I).

Im Ladebetriebszustand LB fließt kein oder ein vergleichsweise geringer Ladestrom. So wird die Batterie 4 nicht oder lediglich in vernachlässigbarem Maße geladen, weshalb der oben beschriebene Vorgang als Simulation des Ladens der Batterie 4 bezeichnet wird.
Aus den Ergebnissen der Impedanzspektroskopie, insbesondere den Amplituden des Wechselstroms und der Wechselspannung sowie deren Phasenversatz zueinander sowie einer Frequenzabhängigkeit der daraus bestimmten Impedanz der Batterie 4, wird darauf folgend ein den Zustand der Batterie 4 repräsentierender Wert W ermittelt (Schritt C). Beispielsweise wird mittels des derart erfassten Impedanzspektrums die Temperatur als Wert W der Batterie 4 durch einen Vergleich des Impedanzspektrums mit einer in der Steuervorrichtung 24 hinterlegten Tabelle ermittelt. Hierbei ist unter dem Zustand insbesondere eine Funktionsfähigkeit oder ein Alterungszustand der Batterie 4 zu verstehen, welcher die aktuelle Leistungsfähigkeit der Batterie oder die Leistungsfähigkeit der Batterie im Vergleich zur Leistungsfähigkeit einer solchen Batterie 4 im Neuzustand repräsentiert. Weiterhin umfasst der Zustand, ob und gegebenenfalls wie oder in welchem Maße die Batterie 4 beschädigt ist, deren Temperatur und/oder deren Ladezustand SOC.

In einer alternativen, nicht weiter dargestellten und nicht erfindungsgemäßen Variante des Verfahrens wird das Laden der Batterie 4 nicht simuliert, sondern die Batterie wird tatsächlich mittels der Vorrichtung 2 geladen. Hierbei ist die Vorrichtung 2 in die Ladesäule 52 integriert. Die oben dargelegten Verfahrensschritte finden dabei in analoger Weise statt, lediglich wird die Batterie 4 ein Ladestrom mit einer für das Laden, insbesondere für einen Schnelladevorgang, geeigneten Stromstärke beaufschlagt.

### Bezugszeichenliste

- 2: Vorrichtung
- 4: (Traktions-)Batterie
- 6: Kraftfahrzeug
- 8: Ladestecker
- 10: Gleichstromkontakt
- 12: Impedanzspektroskopieeinheit
- 14a: Anschluss für die Speiseleitung
- 14b: Anschluss für die Messleitung
- 16: Speiseleitung
- 18: Messleitung
- 20: Kommunikationskontakt
- 22: Steuervorrichtung
- 24: Steuereinheit
- 26: Batterieladesystem
- 28: Steuereingang der Impedanzspektroskopieeinheit
- 30: Gehäuse des Ladesteckers
- 32: Anschluss für ein Versorgungsnetz
- 34: Versorgungsnetz
- 36: Gleichrichters
- 38a: positiver Anschluss des Gleichrichters
- 38b: negativer Anschluss des Gleichrichters
- 40: Diode
- 42: Stromüberwachungseinheit
- 44: Strommessgerät
- 46: Vergleichseinheit
- 48: Steuereingang des Schalters
- 50: Schalter
- 52: Ladesäule
- 54: Gleichstrom-Ladeschnittstelle
- 56: Ladeanschluss
- 57: Anschlusspol
- 58: Kommunikationsanschluss
- 60: Spannungsmessgerät
- 62: Schutzschalter

- A: Antwortsignal
- B: Bereitstellen der Ladespannung
- C: Ermitteln des Wertes
- E: Einstellen des Ladespannung
- I: Impedanzspektroskopie
- K: Kommunikationsaufbau
- L: Erfassen des Ladezustands
- LB: Ladebetriebszustand
- M: Simulation
- S: Spektroskopiesignal
- SOC: Ladezustand der Batterie
- U_{B}: Batteriespannung
- U_{L}: Ladespannung
- V: Verfahrensschritt
- W: Wert

## Patentansprüche

1. Verfahren zum Erfassen des Zustands einer Batterie (4) eines elektrisch angetriebenen Kraftfahrzeugs (6) mit einer Vorrichtung (2),
- wobei die Vorrichtung (2) einen Ladestecker (8) mit Gleichstromkontakten (10) für die Zuführung einer Ladespannung (U_{L}) an die Batterie (4), und eine Impedanzspektroskopieeinheit (12), die sowohl zum Zuführen eines Spektroskopiesignals (S) an die Batterie (4) als auch zum Erfassen eines Antwortsignals (A) mit den Gleichstromkontakten (10) des Ladesteckers (8) verbunden ist, aufweist, wobei der Ladestecker (8) zum Anschließen an eine Gleichstrom-Ladeschnittstelle (54) des elektrisch angetriebenen Kraftfahrzeugs (6) vorgesehen und eingerichtet ist, und wobei die Impedanzspektroskopieeinheit (12) zwei Speiseleitungen (16) zum Zuführen des Spektroskopiesignals (S) und zwei Messleitungen (18) zum Erfassen des Antwortsignals (A) aufweist, wobei mit jedem der Gleichstromkontakte (10) jeweils eine der Speiseleitungen (16) sowie eine der Messleitungen (18) verbunden ist,
- wobei der Ladestecker (8) mit der Gleichstrom-Ladeschnittstelle (54) des Kraftahrzeugs (6) verbunden wird,
- wobei ein die Batterie (4) umfassendes Batterieladesystem (26) in einen Ladebetriebszustand (LB) versetzt wird indem ein Laden der Batterie (4) mittels einer Ladesäule (52) simuliert wird, wobei kein oder ein vergleichsweise geringer Ladestrom fließt, welcher die Batterie (4) nicht oder in lediglich vernachlässigbarem Maße lädt,
- wobei eine Impedanzspektroskopie der Batterie (4) durchgeführt wird, und
- wobei aus den Ergebnissen der Impedanzspektroskopie ein den Zustand der Batterie (4) repräsentierender Wert (W) ermittelt wird.

2. Verfahren nach Anspruch 1,
**dadurch gekennzeichnet,**
- **dass** der Ladezustand (SOC) der Batterie (4) oder eine Batteriespannung (U_{B}) erfasst wird,
- **dass** in Abhängigkeit des erfassten Ladezustands (SOC) bzw. der erfassten Batteriespannung (U_{B}) die Ladespannung (U_{L}) für die Batterie (4) an den Gleichstromkontakten (10) des Ladesteckers (8) eingestellt wird, und
- **dass** die eingestellte Ladespannung (U_{L}) dem Batterieladesystem (26) bereitgestellt wird.

## Claims

1. Method for detecting the state of a battery (4) of an electrically driven motor vehicle (6) comprising a device (2),
- wherein the device (2) has a charging plug (8) comprising DC contacts (10) for feeding a charging voltage (U_{L}) to the battery (4) and has an impedance spectroscopy unit (12), which is connected to the DC contacts (10) of the charging plug (8) both for feeding a spectroscopy signal (S) to the battery (4) and for detecting a response signal (A), wherein the charging plug (8) is provided and set up for connection to a DC charging interface (54) of the electrically driven motor vehicle (6), and wherein the impedance spectroscopy unit (12) has two feed lines (16) for feeding the spectroscopy signal (S) and two measurement lines (18) for detecting the response signal (A), wherein in each case one of the feed lines (16) and one of the measurement lines (18) is connected to each of the DC contacts (10),
- wherein the charging plug (8) is connected to the DC charging interface (54) of the motor vehicle (6),
- wherein a battery charging system (26) comprising the battery (4) is set to a charging operating state (LB) by virtue of a charging of the battery (4) by means of a charging column (52) being simulated, wherein no or a comparatively low charging current flows, which does not charge the battery (4) or only charges it to a negligible extent,
- wherein an impedance spectroscopy of the battery (4) is carried out, and
- wherein a value (W) representing the state of the battery (4) is determined from the results of the impedance spectroscopy.

2. Method according to Claim 1,
**characterized in that**
- the state of charge (SOC) of the battery (4) or a battery voltage (U_{B}) is detected,
- the charging voltage (U_{L}) for the battery (4) at the DC contacts (10) of the charging plug (8) is set depending on the detected state of charge (SOC) or the detected battery voltage (U_{B}), and
- the set charging voltage (U_{L}) is provided to the battery charging system (26).

## Revendications

1. Procédé pour détecter l'état d'une batterie (4) d'un véhicule automobile (6) à propulsion électrique comprenant un dispositif (2),
- le dispositif (2) possédant une fiche de charge (8) pourvue de contacts de courant continu (10) pour l'amenée d'une tension de charge (U_{L}) à la batterie (4), et une unité de spectroscopie d'impédance (12), qui est reliée aux contacts de courant continu (10) de la fiche de charge (8) à la fois pour l'amenée d'un signal de spectroscopie (S) à la batterie (4) et pour l'acquisition d'un signal de réponse (A), la fiche de charge (8) étant prévue et conçue pour le raccordement à une interface de charge à courant continu (54) du véhicule automobile (6) à propulsion électrique, l'unité de spectroscopie d'impédance (12) possédant deux lignes d'alimentation (16) destinées à l'amenée du signal de spectroscopie (S) et deux lignes de mesure (18) destinées à l'acquisition du signal de réponse (A), l'une des lignes d'alimentation (16) ainsi que l'une des lignes de mesure (18) étant respectivement reliées à chacun des contacts de courant continu (10),
- la fiche de charge (8) étant reliée à l'interface de charge à courant continu (54) du véhicule automobile (6),
- un système de charge de batterie (26) comprenant la batterie (4) étant amené dans un état opérationnel de charge (LB) en simulant une charge de la batterie (4) au moyen d'une colonne de charge (52), un courant de charge nul ou relativement faible circulant, lequel ne charge pas la batterie (4) ou la charge seulement dans une mesure négligeable,
- une spectroscopie d'impédance de la batterie (4) étant effectuée et
- une valeur (W) représentant l'état de la batterie (4) étant déterminée à partir des résultats de la spectroscopie d'impédance.

2. Procédé selon la revendication 1, **caractérisé en ce que**
- l'état de charge (SOC) de la batterie (4) ou une tension de batterie (U_{B}) est détecté,
- la tension de charge (U_{L}) pour la batterie (4) au niveau des contacts de courant continu (10) de la fiche de charge (8) est réglée en fonction de l'état de charge (SOC) détecté ou de la tension de batterie (U_{B}) détectée, et
- la tension de charge (U_{L}) réglée est fournie au système de charge de batterie (26).
